# EUROPEAN PATENT APPLICATION

(11) **EP 2 363 878 A1**
(43) Date of publication of application: **07.09.2011**
(21) Application number: 10002179.9
(22) Date of filing: 03.03.2010
(51) Int. Cl.: H01L 21/68

(54) **Flip-chip led module fabrication method**

(71) Applicant: ENCRLIGHTING Corp., Luzhu Township T'ao yuan County (TW)
(72) Inventor: Yang, Yueh-Hsun, Taipei City (TW)
(74) Representative: Glawe, Delfs, Moll

(57) **Abstract**

A flip-chip LED module fabrication method includes the steps of (a) growing an epitaxial layer consisting of a N-type semiconductor layer (12), a light-emitting layer (13) and a P-type semiconductor layer (14) on a wafer substrate (11), (b) dividing the wafer into individual light-emitting chips (1), (c) selecting qualified light-emitting chips, (d) coating an UV-curable adhesive (3) on one side of a film (2) and then bonding the selected light-emitting chips (1) to the film by means of the UV-curable adhesive (3), (e) curing the UV-curable adhesive (3) with ultraviolet rays, and (f) operating push-up needles (41) of an equipment (4) to knock the opposite side of the film (2) to let the light-emitting chips (1) be separated from the film without causing damage.

## Description

### BACKGROUND OF THE INVENTION

### 1. Field of the Invention:

The present invention relates to LED module fabrication technology and more particularly, to a flip-chip LED module fabrication method, which uses ultraviolet rays to cure a UV-curable adhesive that bonds light-emitting chips to a film, and push-up needles to knock the film for causing separation of the light-emitting chips from the film after the UV-curable adhesive has been cured, avoiding damage and improving the yield rate.

### 2. Description of the Related Art:

Many different types of light emitting apparatus are commercially available. Following the trend of the next generation green of environmental protection, LED (light emitting diode), more particularly, white LED has been intensively used in street lamps, tunnel lamps, hand lamps, sign boards, home lightings and backlight modules for LCD panel for the advantages of power-saving, small size, high stability and high reliability characteristics.

Further, to achieve high brightness and low power consumption, a LED package product must have excellent heat dissipation and light extraction efficiency. The factor of heat dissipation efficiency has been greatly emphasized. If waste heat cannot be quickly dissipated during operation of a LED package product, the life cycle and reliability of the product will be badly affected. The optical design is also important in a LED package product. How to effectively guide light emitted light? The light emitting angle and direction are the points on which the design of the product to be focused.

For a lead frame packaging structure, it requires a series of processes including die attach, wire bond and molding. A light-emitting chip comprises a sapphire substrate, an N-type gallium nitride ohmic contact layer, a light-emitting layer, a P-type gallium nitride ohmic contact layer and a light-transmissive conducting layer. Further, P-type electrode pads and N-type electrode pads are respectively grown on the light-transmissive conducting layer and the N-type gallium nitride ohmic contact layer. During die attach, the non-epitaxial side of the sapphire substrate is bonded to the lead frame with conductive silver glue, tin solder paste or gold-tin solder, and then gold or aluminum wires are bonded between the light-emitting chips and the lead frame or substrate. Thereafter, a phosphor-contained epoxy is molded on the light-emitting chips for protection and heated to perform cross-linking, enhancing the hardness and reducing moisture absorption. However, the low heat dissipation coefficient of sapphire substrate of this packaging structure limits the heat dissipation performance of the light-emitting chips. Further, the high thickness of this packaging structure imparts a barrier to the transfer of heat energy. Further, when the light emitted by the light-emitting layer goes through the light-transmissive conducting layer and the phosphor-contained epoxy resin, the P-type electrode pads block a part of the emitted light, lowering the light emitting efficiency of the LED module.

In order to eliminate the drawback of low light emitting efficiency due to the fact that the P-type electrode pad blocks a significant part of the light emitted from the light-emitting chips, flip-chip packaging is created to increase the effective light emitting surface area. According to the conventional flip-chip packaging method, a buffer layer and an N-type gallium nitride ohmic contact layer are grown on a sapphire substrate, and a light-emitting layer and a P-type gallium nitride ohmic contact layer are grown at the center. The P-type gallium nitride ohmic contact layer is connected to an external heat sink through P-type electrode pads. Further, N-type electrodes are grown at two opposite lateral sides relative to the light-emitting layer. Further, one of the N-type electrodes is connected to the external heat sink through an N-type electrode pad. According to this packaging method, the major part of the light-emitting surface is exposed to the outside, enhancing the light emitting efficiency. There are manufacturers to have multiple light-emitting chips be bonded to a gallium nitride substrate or silicon substrate so that the gallium nitride substrate or silicon substrate can be further bonded to a silver-coated copper material with conductive silver glue or soft solder. During operation of the light-emitting chips, generated heat energy can be rapidly transferred from the light-emitting chips through electrode pads to the silver-coated copper material for quick dissipation. This method uses a gallium nitride substrate or silicon substrate to substitute for a sapphire substrate, improving the heat dissipation efficiency. However, the material cost of this method is much higher than the use of a sapphire substrate. Due to cost considerations, the sapphire substrate is commonly adopted.

Further, the fabrication of a LED module includes the steps of epitaxy formation, wafer sawing, chip selection, film bonding, chip separation, chip bonding and flip-chip packaging. After formation of the epitaxial layer, the wafer is divided into individual light-emitting chips. After sorting, selected light-emitting chips are bonded to a film (blue gum) so that batches of light-emitting chips can be stored in an inventory, or received a further separation process. During the separation process, vacuum pickup tools are operated to pick up the light-emitting chips and to carry the light-emitting chips to a next station for further bonding and packaging. When separating the light-emitting chips from the film, push-up needles of an equipment are operated to knock the film. However, because the light-emitting chips are adhered to the film with an adhesive, much push force must be applied to the push-up needles against the film for causing separation of the light-emitting chips from the film. However, because the epitaxial layer (of the buffer layer, N-type gallium nitride ohmic contact layer, light-emitting layer and P-type gallium nitride ohmic contact layer) is relatively thinner than the sapphire substrate, the impact energy from the push-up needles may cause damage to the light-emitting chips due to an excessive applied pressure, improper knocking position or improper parameter setting. Thus, this conventional flip-chip packaging method has the drawbacks of low yield rate and high manufacturing cost.

### SUMMARY OF THE INVENTION

The present invention has been accomplished under the circumstances in view. It is one object of the present invention to provide a flip-chip LED module fabrication method, which improves the product quality and the yield rate. It is another object of the present invention to provide a flip-chip LED module fabrication method, which greatly saves the flip-chip LED module manufacturing cost.

To achieve these and other objects of the present invention, a flip-chip LED module fabrication method comprises the steps of (a) growing in proper order a N-type semiconductor layer, a light-emitting layer and a P-type semiconductor layer on a wafer substrate, thereby forming an epitaxial layer on the wafer substrate; (b) dividing the wafer thus obtained from the step (a) into a plurality of individual light-emitting chips; (c) selecting qualified light-emitting chips from the divided individual light-emitting chips; (d) coating an ultraviolet curable adhesive on one side of a film and then bonding the selected light-emitting chips to the film by means of the ultraviolet curable adhesive; (e) using an UV exposure equipment to radiate the ultraviolet curable adhesive with ultraviolet rays, thereby curing the ultraviolet curable adhesive; and (f) operating push-up needles of an equipment to knock the opposite side of the film, thereby separating the light-emitting chips from the film. According to the present invention, the UV-curable adhesive is cured with ultraviolet rays before separation of the light-emitting chips from the film, the viscosity of the adhesive is greatly reduced. At this time, the material property of the UV-curable adhesive is changed, i.e., the UV-curable adhesive becomes fragile. Thereafter, the light-emitting chips can be separated from the film easily by means of the application of the metal push-up needles with less pressure without damaging the epitaxial layer of the light-emitting chips, improving the yield rate and saving the manufacturing cost.

### BRIEF DESCRIPTION OF THE DRAWINGS

FIG. 1 is a flip-chip LED module fabrication flow chart in accordance with the present invention.

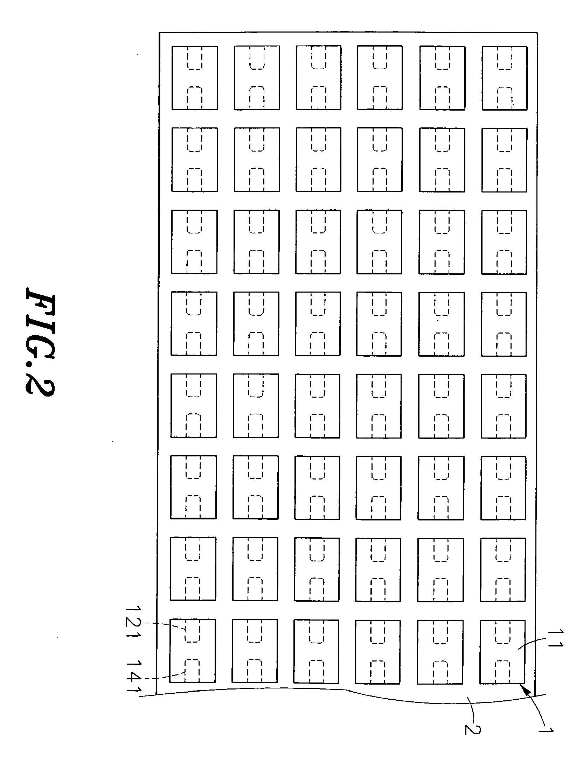

FIG. 2 is a schematic plain view of the present invention, showing a plurality of light-emitting chips bonded to a film and arranged in an array.

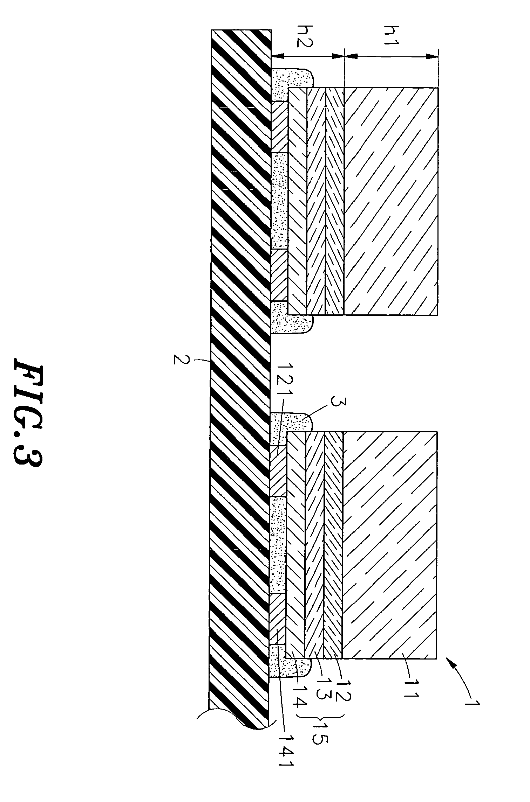

FIG. 3 is a schematic sectional side view of the present invention, showing light-emitting chips bonded to the film.

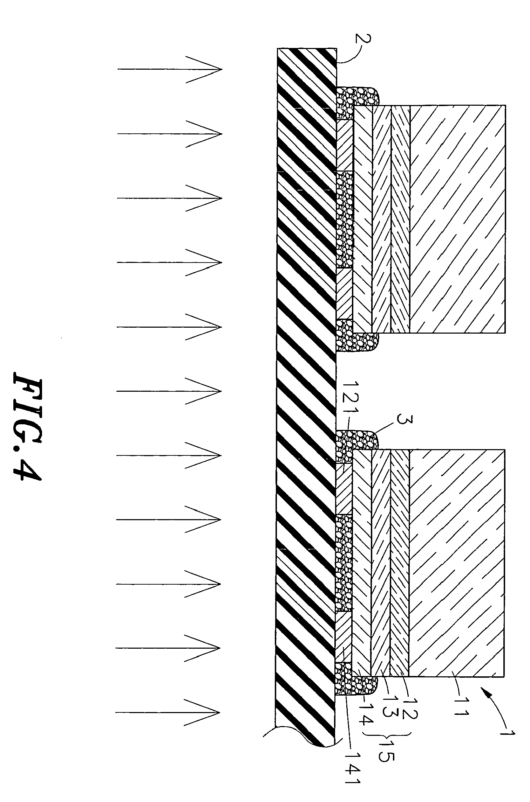

FIG. 4 is a schematic drawing of the present invention, showing the application of an UV exposure process.

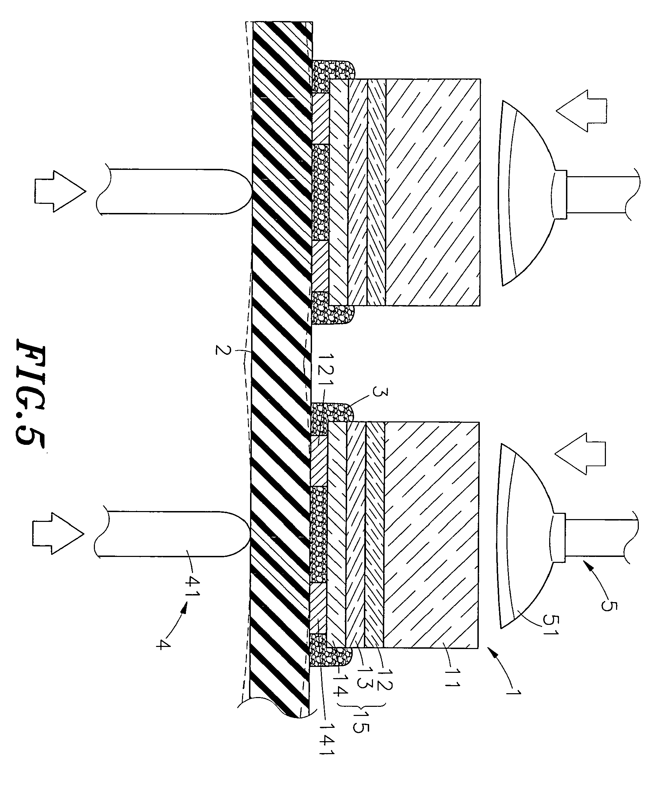

FIG. 5 is a schematic drawing of the present invention, showing the performance of a chip separation process.

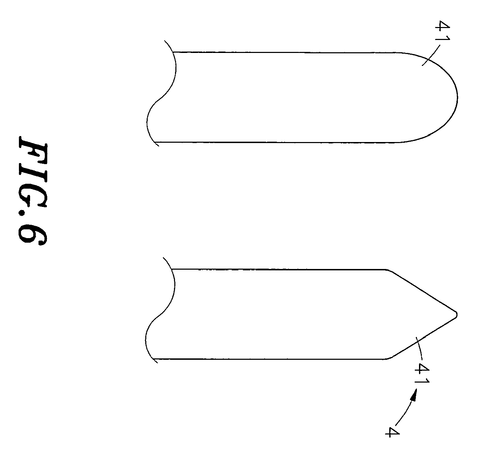

FIG. 6 illustrates two different types of push-up needles according to the present invention.

### DETAILED DESCRIPTION OF THE PREFERRED EMBODIMENT

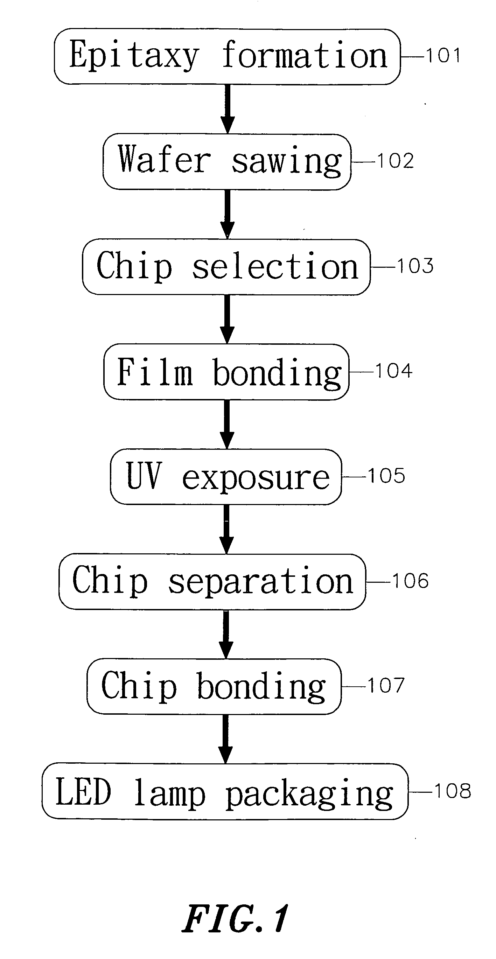

Referring to FIGS. 1∼4, a flip-chip LED module fabrication method in accordance with the present invention includes the steps of:
- (101): Epitaxy formation, where a N-type semiconductor layer **12**, a light-emitting layer **13** and a P-type semiconductor layer **14** are grown one after another on a wafer substrate **11**, and then a light-transmissive conducting layer (not shown) is grown on the P-type semiconductor layer **14**, and then N-type electrode pads **121** and P-type electrode pads **141** are separately grown on the light-transmissive conducting layer;
- (102): Wafer sawing, where the wafer thus obtained from step (101) is divided into individual light-emitting chips **1**;
- (103): Chip selection, where the light-emitting chips **1** are sorted so that qualified light-emitting chips **1** are picked up for application;
- (104): Film bonding, where an UV (ultraviolet) adhesive **3** is coated on one side of a film **2** and then multiple selected light-emitting chips **1** are bonded to the film **2** by means of the UV-curable adhesive **3**;
- (105): UV exposure, where an UV exposure equipment is used to radiate the UV-curable adhesive **3** at the film **2** with ultraviolet rays, thereby curing the UV-curable adhesive **3** and lowering bonding power between the light-emitting chips **1** and the film **2**;
- (106): Separation, where the light-emitting chips **1** are separated from the film **2** by means of drive push-up needles **41** of an equipment **4** to knock the opposite side of the film **2**, and then vacuum pickup devices **51** of a conveyer system **5** are operated to suck up the light-emitting chips **1** and to carry the light-emitting chips **1** to a designated place;
- (107): Chip bonding, where the N-type electrode pads **121** and P-type electrode pads **141** of the light-emitting chips **1** are bonded to respective solder pads of a circuit substrate (not shown) with an electric conductive adhesive or solder paste and then encapsulated with a resin, thereby forming a flip-chip LED module; and
- (108): LED lamp packaging, where the flip-chip LED module is packaged with an external lighting fixture, forming a finished LED lamp.

As stated above, the flip-chip LED module fabrication method is to grow an epitaxial layer **15**, i.e., to grow in proper order a N-type semiconductor layer **12**, a light-emitting layer **13** and a P-type semiconductor layer **14** on a wafer substrate **11**, and then to grow a light-transmissive conducting layer on the P-type semiconductor layer **14**, and then to grow N-type electrode pads **121** and P-type electrode pads **141** on the light-transmissive conducting layer by means of exposure, developing and lift-off techniques. As these exposure, developing and lift-off techniques are of the known art, no further detailed description in this regard is necessary. Thereafter, the wafer thus obtained is divided into individual light-emitting chips **1**, and then qualified light-emitting chips **1** are picked up for application. Thereafter, an UV (ultraviolet) adhesive **3** is coated on one side of a film **2** by means of screen printing, roller-coating or spray-coating. The UV-curable adhesive **3** can be obtained from an UV-curable resin or UV-curable polymer. Thereafter, multiple selected light-emitting chips **1** are bonded to the film **2** by means of the UV-curable adhesive **3** in an array. Thus, batches of light-emitting chips **1** can be stored in an inventory, or delivered to downstream manufacturers for further packaging. Before packaging, the light-emitting chips **1** must be separated from the film **2**. At this time, an UV exposure equipment is used to radiate the UV-curable adhesive **3** at the film **2** with ultraviolet rays, thereby curing the UV-curable adhesive **3**. When the UV-curable adhesive **2** is cured, its viscosity is greatly reduced. At this time, the material property of the UV-curable adhesive **2** is changed, i.e., the UV-curable adhesive **2** becomes fragile. Thereafter, metal push-up needles **41** of **an** equipment **4** are driven to knock the opposite side of the film **2**, thereby separating the light-emitting chips **1** from the film **2** with less pressure. This chip separation method enables the light-emitting chips **1** to be separated from the film **2** easily without damaging the epitaxial layer **15** of the light-emitting chips **1**, improving the yield rate and saving the manufacturing cost.

When separating the light-emitting chips **1** from the film **2**, vacuum pickup devices **51** of a conveyer system **5** are operated to suck up the light-emitting chips **1** and to carry the light-emitting chips **1** to a designated place. Thereafter, the N-type electrode pads **121** and P-type electrode pads **141** of the light-emitting chips **1** are bonded to respective solder pads of a circuit substrate (not shown) with an electric conductive adhesive or solder paste. The circuit substrate can have a circuit layout on one side. By means of the circuit layout on one side of each of the two opposite sides of the circuit substrate, the rectangular light-emitting chips **1** are electrically connected in series or parallel, thereby forming a single-sided or double-sided light-emitting structure, which is further processed into a flip-chip LED module through a phosphor-contained resin encapsulation and baking process. At final, the flip-chip LED module is packaged with an external lighting fixture, forming a finished LED lamp.

Further, during the aforesaid fabrication process, the wafer substrate **11** for the light-emitting chips **1** can be selected from light-transmissive sapphire, SiC (silicon carbon), ZnO (zinc oxide), MgO (magnesium oxide), Ga₂O₃ (gallium oxide) AlGaN (aluminum gallium nitride), GaLiO (gallium lithium oxide), AlliO (aluminum lithium oxide) or Spinel. Further, the N-type semiconductor layer **12** and the P-type semiconductor layer **14** can be selected from the material group consisting of titanium, gold, aluminum, chrome and their alloys. Further, the N-type semiconductor layer **12**, the light-emitting layer **13** and the P-type semiconductor layer **14** are grown in proper order on the wafer substrate **11**, thereby forming an epitaxial layer **15**. Preferably, the wafer substrate **11** has a thickness within about 80∼90µm. Preferably, the epitaxial layer **15** has a thickness within about 5∼10µm. In actual practice, the aforesaid thickness ranges are not a limitation. However, the thicknesses of the wafer substrate **11** and the epitaxial layer **15** must facilitate bonding of the light-emitting chips **1** to the film **2** by the UV-curable adhesive **3** and curing of the UV-curable adhesive **3** with ultraviolet rays. Further, the wavelength of the ultraviolet rays is preferably within the range of 400∼430nm. After the UV-curable adhesive **3** is cured to lower its viscosity, the light-emitting chips **1** can be separated from the film **2** easily by the push-up needles **41** of an equipment **4**. Further, subject to the size or weight of the light-emitting chips **1**, different types (round tip type or pointed tip type) of push-up needles **41** may be selectively used, avoiding damaging the N-type semiconductor layer **12**, light-emitting layer **13** and P-type semiconductor layer **14** of the epitaxial layer **15** due to an excessive applied force, improper knocking position or improper parameter setting. Thus, the invention greatly improves the yield rate and saves much the manufacturing cost.

Although a particular embodiment of the invention has been described in detail for purposes of illustration, various modifications and enhancements may be made without departing from the spirit and scope of the invention. Accordingly, the invention is not to be limited except as by the appended claims.

## Claims

1. A flip-chip LED module fabrication method, comprising the steps of:
(a) growing in proper order a N-type semiconductor layer (12), a light-emitting layer (13) and a P-type semiconductor layer (14) on a wafer substrate (11), thereby forming an epitaxial layer (15) on said wafer substrate (11);
(b) dividing the wafer thus obtained from the step (a) into a plurality of individual light-emitting chips (1);
(c) selecting qualified light-emitting chips (1) from the divided individual light-emitting chips (1);
(d) coating an ultraviolet curable adhesive on one side of a film (2) and then bonding the selected light-emitting chips (1) to said film (2) by means of said ultraviolet curable adhesive;
(e) using an UV exposure equipment (4) to radiate said ultraviolet curable adhesive with ultraviolet rays, thereby curing said ultraviolet curable adhesive; and
(f) operating push-up needles of an equipment (4) to knock the opposite side of said film (2), thereby separating the light-emitting chips (1) from said film (2).

2. The flip-chip LED module fabrication method as claimed in claim 1, wherein the step (a) further comprises a sub-step of growing a light-transmissive conducting layer on said P-type semiconductor layer (14) of said epitaxial layer (15) and then separately growing N-type electrode pads (121) and P-type electrode pads (141) are on said light-transmissive conducting layer.

3. The flip-chip LED module fabrication method as claimed in claim 2, wherein said N-type electrode pads (121) and said P-type electrode pads (141) are grown on said light-transmissive conducting layer during the step (a) by means of exposure, developing and lift-off techniques.

4. The flip-chip LED module fabrication method as claimed in claim 1, wherein said wafer substrate (11) used during the step (a) preferably has a thickness within about 80∼90)µm; said epitaxial layer (15) preferably has a thickness within about 5∼10µm.

5. The flip-chip LED module fabrication method as claimed in claim 1, wherein said wafer substrate (11) used during the step (a) is selected from the group consisting of light-transmissive sapphire, SiC (silicon carbon), ZnO (zinc oxide), MgO (magnesium oxide), Ga₂O₃ (gallium oxide) AlGaN (aluminum gallium nitride), GaLiO (gallium lithium oxide), AlliO (aluminum lithium oxide) and Spinel.

6. The flip-chip LED module fabrication method as claimed in claim 1, wherein said N-type semiconductor layer (12) and said P-type semiconductor layer (14) that are grown on said substrate during the step (a) are selected from the material group consisting of titanium, gold, aluminum, chrome and their alloys.

7. The flip-chip LED module fabrication method as claimed in claim 1, wherein said ultraviolet curable adhesive is coated on said film (2) during the step (d) by means of one of the techniques of screen printing, roller-coating and spray-coating.

8. The flip-chip LED module fabrication method as claimed in claim 1, wherein said ultraviolet curable adhesive used during the step (d) is selected from the material group consisting of UV-curable resins and UV-curable polymers.

9. The flip-chip LED module fabrication method as claimed in claim 1, wherein the ultraviolet rays applied during the step (e) have a wavelength within 400∼430nm.

10. The flip-chip LED module fabrication method as claimed in claim 1, wherein the push-up needles used during the step (f) each have a round tip.

11. The flip-chip LED module fabrication method as claimed in claim 1, wherein the push-up needles used during the step (f) each have a pointed tip.

12. The flip-chip LED module fabrication method as claimed in claim 1, wherein vacuum pickup means of a conveyer system (5) is used during the step (f) to pick up the light-emitting chips (1) that are from said film (2) and to carry the light-emitting chips (1) to a designated place.

13. The flip-chip LED module fabrication method as claimed in claim 1, further comprising the step (g) of bonding the N-type electrode pads (121) and P-type electrode pads (141) of the light-emitting chips (1) after separation from said film (2) during step (f) to respective solder pads of a circuit substrate with an electric conductive adhesive or solder paste for enabling the light-emitting chips (1) to be electrically connected in series or parallel by a circuit layout on at least one of two opposite sides of said circuit substrate;

14. The flip-chip LED module fabrication method as claimed in claim 13, further comprising the step (h) of encapsulating the light-emitting chips (1) on said circuit substrate with a phosphor-contained resin and then baking the phosphor-contained resin after finish of the step (g), thereby forming a flip-chip LED module.

15. The flip-chip LED module fabrication method as claimed in claim 14, further comprising the step (i) of packaging said flip-chip LED module with an external lighting fixture after finish of the step (h), forming a finished LED lamp.
